# EUROPEAN PATENT APPLICATION

(11) **EP 1 780 776 A1**
(43) Date of publication of application: **02.05.2007**
(21) Application number: 05425762.1
(22) Date of filing: 28.10.2005
(51) Int. Cl.: H01L 21/268, H01L 29/78

(54) **Process for manufacturing a high-scale-integration mos device**

(71) Applicant: STMicroelectronics S.r.l., 20041 Agrate Brianza (Milano) (IT); Lambda Physik AG, 37079 Göttingen (DE); CONSIGLIO NAZIONALE DELLE RICERCHE, 00185 Roma (IT)
(72) Inventor: Simon, Frank, 37081 Goettingen (DE); Magri, Angelo, 95032 Belpasso (IT); Fortunato, Gugliemo, 00156 Roma (IT); Privitera, Vittorio, 95021 Aci Castello (IT)
(74) Representative: Cerbaro, Elena

(57) **Abstract**

A process for manufacturing a MOS device (30) envisages the steps of: forming a gate structure (24) on a top surface (20a) of a semiconductor layer (20); forming a doped source/drain region (28) within a surface portion of the semiconductor layer (20) in a position adjacent to the gate structure (24); and irradiating the doped source/drain region (28) with an electromagnetic radiation (12a, 12b). The electromagnetic radiation (12a, 12b) is directed towards the top surface (20a) with a propagation direction having an incidence angle (+α,-α) non-zero with respect to the normal (n) to the top surface (20a). In particular, the electromagnetic radiation (12) is an excimer-laser radiation and comprises a first beam (12a) and a second beam (12b) having incidence angles (+α, -α) opposite to one another with respect to the normal (n).

## Description

The present invention relates to a process for manufacturing a high-scale-integration MOS (Metal-Oxide-Semiconductor) device.

As is known, the achievement of a high-scale integration in the manufacturing of MOS devices, in particular smaller than 1 µm (ULSI - Ultra Large-Scale Integration), involves a severe reduction in the vertical and lateral size of the body, source and drain regions (the latter in the case of lateral MOS devices) in order to achieve shallow or ultra-shallow junctions. Said size reduction could in principle be achieved by reducing the thermal budget associated to the MOS device, but said solution is not efficient for activation of the heavily doped shallow regions that constitute the source and drain regions (in what follows source/drain regions) of the device.

In the case of N-channel devices, implants with low-diffusivity dopants, such as arsenic (As), are usually exploited, followed by a rapid thermal annealing (RTA) for dopant activation. As compared to a traditional thermal treatment, RTA enables a reduction in the thermal budget of the process; however, it is not efficient in the case of high-dose implants. In particular, RTA does not enable an efficient removal of crystallographic defects due to ion implantation, which are responsible for the degradation of the body/drain junctions and/or gate oxide electrical performance. In the case of P-channel devices, the high diffusivity of boron (B) dopant atoms, normally used for the implants, does not enable shallow junctions to be obtained. At the same time, alternative low-diffusivity dopants, such as for instance indium (In), are not very suitable for the source/drain implants, on account of the poor electrical activation properties.

Conventional thermal treatments, even though rapid annealing is exploited, do not in any case enable an accurate control of the diffusion of the dopant atoms, and are consequently not suitable for the manufacturing of ultra-shallow doped regions, wherein process repeatability is fundamental for a close control of characteristics such as the threshold voltage and the channel length.

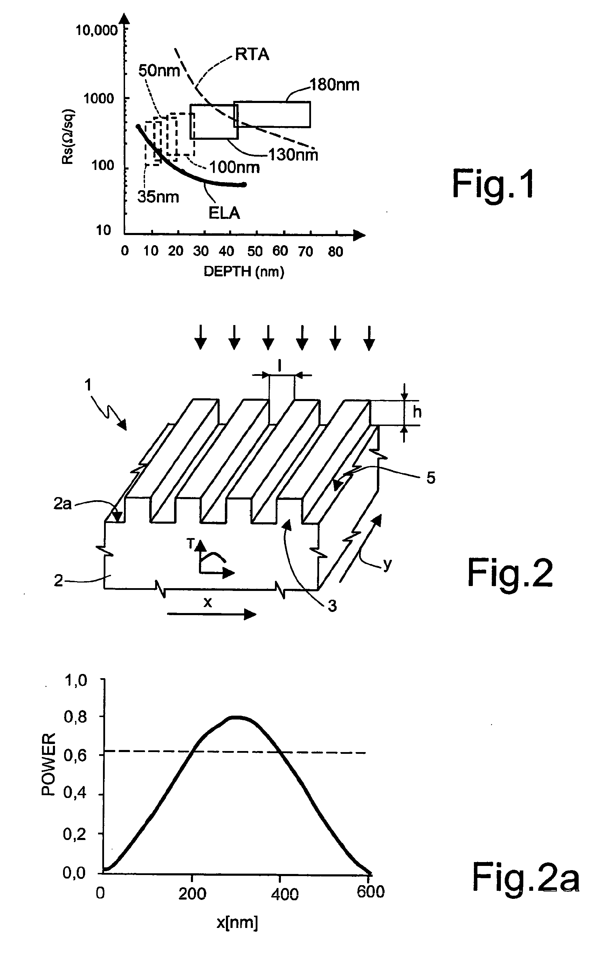

During the last few years, the use of alternative techniques has consequently been proposed, in particular of excimer-laser irradiation techniques, for local heating, and possibly melting, of silicon regions, to enable rapid diffusion and activation of dopant atoms. The annealing by laser irradiation, referred to as ELA (Excimer-Laser Annealing), enables extremely shallow doped regions (of a depth smaller than 0.1 µm) to be obtained, with excellent electrical characteristics, in particular with an extremely low sheet resistance. With this regard, Figure 1 shows a graph illustrating the plots of the sheet resistance Rs as a function of junction depth, in the case of traditional RTA technology (dashed line) and of ELA technology (solid line), wherein the boxes correspond to the technology nodes.

In detail, excimer-laser irradiation allows melting of silicon regions to be obtained, with size controllable with extreme precision by tuning the irradiation energy. During melting, the crystallographic defects due to ion implantation are completely eliminated and the dopants diffuse rapidly within the molten region; during a subsequent liquid-phase epitaxy process, the dopant is then incorporated in the re-growth region. Due to the efficient heat dissipation towards underlying silicon regions, the temperature remains sufficiently high for a solid-phase diffusion only for some tens of nanoseconds, a time that is not sufficient for the occurrence of a significant transport of dopant atoms beyond the molten region.

The use of said technology within the process for manufacturing MOS transistor devices, even though particularly advantageous, involves, however, considerable problems. In particular, the laser irradiation for annealing of the doped source/drain regions is carried out after the formation of the gate structures, which comprise, in a known way, a region of silicon oxide surmounted by a gate electrode, normally made of polycrystalline silicon. Consequently, during the ELA process, there is the risk of causing melting and deformation of the gate electrodes.

To overcome the above problem, it has been proposed, for example in US 5,401,666, to exploit the radiation transmission modulation effect of silicon-oxide layers having different thicknesses. In particular, it has been proposed to coat the gate structures on top with a silicon-oxide region having a thickness such as to have maximum reflectivity to the laser radiation at the frequency used, so as to reduce the intensity of the laser radiation absorbed by the underlying gate electrode and consequently limit its deformation; and to coat the source/drain regions, wherein the dopant atoms must be activated, with a silicon-oxide layer having a thickness such as to have minimum reflectivity to the laser radiation, and to maximize the intensity of the laser radiation absorbed by the underlying regions. Furthermore, it has been proposed the simultaneous use of spacers, which are also made of silicon oxide, which coat the side walls of the gate structures, to contain mechanically the molten polysilicon of the gate electrode during the annealing process.

Figure 2 is a schematic perspective cross-sectional view of the geometrical structure of a MOS device 1 of a known type. The MOS device 1 comprises: a substrate 2 having a top surface 2a; gate structures 3 (illustrated in an extremely simplified way), formed on the top surface 2a of the substrate 2, which follow one another in a first direction x and extend, parallel to one another, in a second direction y perpendicular to the first direction x; and source/drain regions (not illustrated), made up of doped regions formed in surface portions of the substrate 2 arranged in a position adjacent to, and partially below, the gate structures 3. In particular, the source/drain regions are formed within source/drain windows 5, defined by gate structures 3 contiguous in the first direction x. The source/drain windows 5 have the shape of narrow channels, for instance having a width 1 of 600 nm, and a height h of 700 nm.

As indicated by the arrows, the laser irradiation for annealing of the source/drain regions and activation of the respective dopants, occurs in a direction normal to the top surface 2a of the substrate 2, within the source/drain windows 5. Due to the wave nature of the laser radiation, and to the small dimensions of the regions to be irradiated, interference phenomena with the side walls of the gate structures 3 occur, with the consequence that peripheral portions of the source/drain regions arranged in the proximity of said walls receive a smaller irradiation intensity with respect to central portions. Such phenomenon is illustrated in Figure 2a, which shows the plot of the transmitted radiation power (in normalized values) as a function of the position x within a source/drain window 5: the irradiation intensity has a minimum at the walls (x = 0, x = 600 nm), and a maximum at the centre of the window. The thermal difference caused by said interference phenomena is moreover accentuated by phenomena of heat dissipation from the aforesaid peripheral portions towards adjacent cold regions of the substrate 2, located below the gate structures 3. There follows a non-uniform heating of the source/drain regions, with the temperature T varying with the distribution illustrated in the detail of Figure 2 within the source/drain windows 5, with a maximum in the central portions of the source/drain regions and a minimum in the peripheral portions thereof.

In order to achieve a sufficient annealing of the peripheral portions of the source/drain regions, with a complete removal of the crystallographic defects, it is consequently necessary to use high irradiation energy density, greater than or equal to 1 J/cm². The use of such energies, however, causes the entire polysilicon of the gate electrode to melt, and the use of thick lateral spacers is therefore necessary to mechanically contain the molten polysilicon. It follows that the laser irradiation cannot sufficiently reach the silicon areas underneath the spacers, where annealing and activation of the dopant atoms cannot thus occur. This is the reason why the processes for manufacturing MOS transistor devices through ELA techniques currently envisage two distinct steps for dopant implantation and activation, in order to form the source/drain regions.

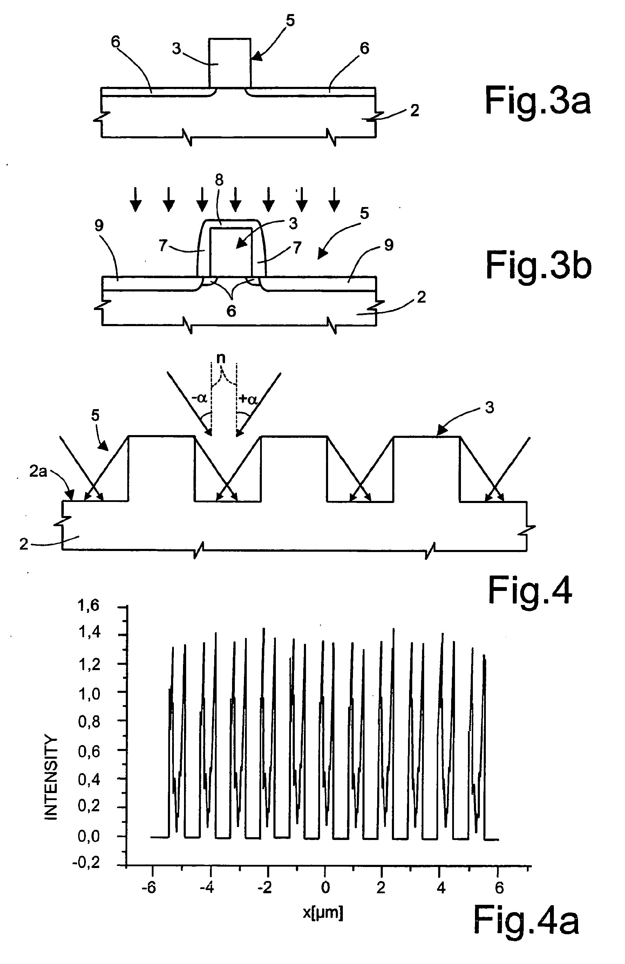

In detail (see Figure 3a), after the formation of the gate structures 3 (shown schematically) on the substrate 2, a low-dose ion implantation is performed within the source/drain windows 5, to obtain lightly doped source/drain regions 6, which are subsequently activated by a traditional thermal process, for example an RTA process. In a subsequent step (Figure 3b), a layer of dielectric material, for example silicon oxide, is deposited, and then anisotropically etched (e.g. by a plasma etching), for the formation of spacers 7, laterally with respect to the gate structures 3, and of protection regions 8, on top of said gate structures 3. Then, a second, heavy-dose, ion implantation is carried out within the source/drain windows 5 in a way self-aligned to the spacers 7, to form heavily doped source/drain regions 9. Next, the heavily doped source/drain regions 9 undergo an ELA process (indicated by the arrows), for activation and diffusion of the dopants.

At the end of the above process, the source/drain regions of the MOS transistor device comprise two distinct regions with different doping levels and different vertical diffusion, and having a different sheet resistance: the lightly doped source regions 6, arranged partially underneath the gate structures 3, which form, together with the body regions (not illustrated), the channel of the MOS transistor device; and the heavily doped source/drain regions 9, adjacent to the lightly doped source/drain regions 6, which act as low-resistivity connections with corresponding contact metallizations (not illustrated).

The manufacturing process previously described can be used to obtain lateral MOS devices, but it is not optimized for vertical diffused MOS (VDMOS) devices, such as power MOS transistors or IGBTs. In this case, in fact, a single heavily doped source region is advantageous for optimization of the on resistance and of the forward transconductance of the devices. Furthermore, in VDMOSs, the threshold voltage is strongly dependent upon the lateral diffusion of the source regions, so that it is necessary to carry out an accurate control of said diffusion in order to obtain a high repeatability of the threshold voltage value. It would thus be advantageous to use a laser irradiation process, which can be accurately controlled, to obtain a single heavily doped source region.

The aim of the present invention is consequently to provide a process for manufacturing a MOS device that will enable the aforementioned disadvantages and problems to be overcome.

According to the present invention there is consequently provided a process for manufacturing a MOS device and a corresponding MOS device, as defined in Claims 1 and 14, respectively.

For a better understanding of the present invention, preferred embodiments thereof are now described purely by way of nonlimiting example and with reference to the attached drawings, wherein:
- Figure 1 shows a graph illustrating the plots of the sheet resistance as a function of junction depth, for different annealing techniques;
- Figure 2 shows a schematic perspective cross-sectional view of the geometrical structure of a MOS device, which undergoes a laser irradiation of a traditional type;
- Figure 2a shows the plot of a transmitted radiation power within a source/drain window of the structure of Figure 2;
- Figures 3a and 3b show successive steps of a process for manufacturing a MOS device, of a known type;
- Figure 4 is a schematic cross-sectional view of the geometrical structure of a MOS device, which undergoes a laser irradiation according to an aspect of the present invention;
- Figure 4a shows the energy intensity distribution within a series of adjacent source/drain windows of the structure of Figure 4;
- Figure 5 is a schematic view of a laser irradiation system configured to carry out the laser irradiation process of Figure 4;
- Figures 6-9 show sections through a wafer of semiconductor material corresponding to successive steps of a process for manufacturing a MOS device, according to an embodiment of the present invention; and
- Figures 10 and 11 show possible variations of steps of the aforesaid manufacturing process.

The general idea underlying the present invention envisages the use, for annealing of doped source/drain regions of a MOS device integrated in a wafer of semiconductor material, of a laser irradiation with beams having a propagation direction which has a non-zero incidence angle α with respect to the normal to the plane in which the surface of the wafer lies. In particular, the incidence angle α is controlled in such a way that the laser radiation reach, in an optimal way, peripheral portions of the source/drain regions, adjacent to respective gate structures. A convenient distribution of the irradiation intensity is thus obtained, such as to achieve a uniform distribution of the temperature within the source/drain regions. In this way, it is possible to reduce the energy density of the laser radiation, in particular down to values in the region of 600-700 mJ/cm² (shared among the incident beams), yet achieving an effective electrical activation of the dopants and an effective removal of the crystallographic defects due to ion implantation, and at the same time controlling in an accurate way the lateral diffusion of the source/drain regions.

In particular, as illustrated schematically in Figure 4, in which similar parts are indicated with the same reference numbers used in Figure 2, the irradiation is performed simultaneously with two laser beams, a first laser beam having a first incidence angle +α, with respect to the normal n to the top surface 2a of the substrate 2, and a second laser beam having an opposite inclination with respect to the first, i.e. having a second incidence angle -α with respect to said normal n, substantially equal and opposite to the first angle +α. The absolute value of the incidence angle α is chosen according to the dimensions of the source/drain windows 5, in such a way that the laser rays are directed within the source/drain windows 5 and reach the peripheral portions of the source/drain regions. Instead, the side walls of the gate structures 3 shade the central portions of the source/drain regions. There follows an energy intensity distribution within the source/drain regions, taking into account the interference effects given by the gate structures 3 above the surface of the substrate 2, having a substantially "U-shape", as shown in Figure 4a (wherein the distribution within a certain number of adjacent source/drain regions is shown in normalized values). In conclusion, a greater absorption of energy by the aforesaid peripheral portions, and a greater uniformity in the distribution of the temperature T are achieved. In detail, the incidence angle α is, in absolute value, smaller than 90°, in particular between 10° and 50°, preferably 30°.

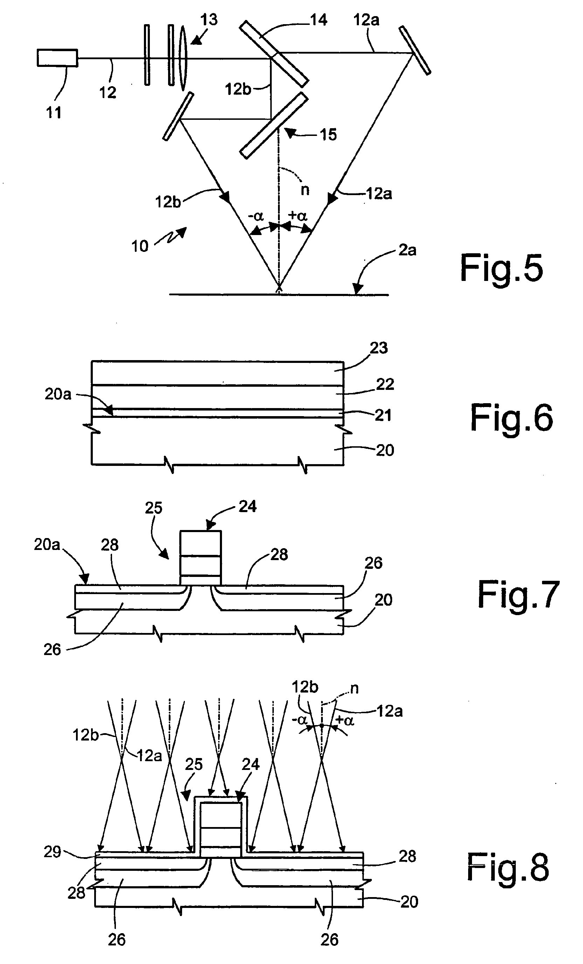

According to an aspect of the present invention, the two laser beams used for irradiation are obtained from a same laser beam, by a splitting process. With this regard, Figure 5 shows a possible implementation of an irradiation system, of a known type, using an excimer-laser beam, which is split into two components, inclined, respectively, at the first incidence angle +α and at the second incidence angle -α, with respect to the normal n to the top surface 2a.

In brief, the irradiation system, designated by 10, comprises: an excimer-laser source 11, which emits a laser beam 12 having a pre-set wavelength; a homogenizer 13, and a beam-splitter 14, arranged in succession along the optical path of the laser beam 12; and a system of mirrors 15. The homogenizer 13 increases the degree of uniformity of the energy density of the laser beam 12, and the beam-splitter 14 splits the laser beam 12 into a first component 12a and a second component 12b, which are directed towards the system of mirrors 15. The system of mirrors 15, via reflections at appropriate angles, is configured to adjust the inclination of the first component 12a and the second component 12b so that they assume, respectively, an incidence angle +α and -α with respect to the normal n.

A process for manufacturing a MOS device will now be described, according to an embodiment of the present invention, which exploits a laser irradiation of the type previously described.

In detail (Figure 6), in a first step of the manufacturing process, within a layer 20 of semiconductor material, for instance of an N type, having a top surface 20a, active areas (not illustrated) are defined in a per-se known manner, at which MOS transistors will be provided. Subsequently, on the layer 20 there are formed in succession: a thin gate-oxide layer 21, for example with a thickness of 10-60 nm; a polysilicon layer 22, preferably doped, which is to form the gate electrodes of the MOS transistors and has a thickness of, for instance, 150-600 nm; and a dielectric layer 23, in particular of thermal silicon oxide, referred to as low thermal oxide (LTO), having a thickness equal to an odd multiple n_{odd} of λ/2/η₁, X being the incident radiation wavelength, and η₁ the relative refraction index of the dielectric layer 23. In the case that λ = 308 nm, and the dielectric layer 23 comprises silicon oxide, the factor λ/2/η₁ is about 50 nm, and the thickness of the dielectric layer 23 is equal to n_{odd} · 50 nm.

Next (see Figure 7), the aforesaid layers are etched in succession through an appropriate etching mask and a selective dry etching, for the formation of gate structures 24 (only one of said gate structures 24 is illustrated in Figure 7, by way of example), and the definition of source/drain windows 25, arranged between adjacent gate structures 24. Then, a first ion implantation is carried out, for instance of a P type with atoms of boron (B) with a dose of 10¹³ to 10¹⁴ atoms/cm² and an energy of 20-150 keV, for the formation of body wells 26 within the source/drain windows 25, in a position adjacent to, and partially below, the gate structures 24. The previously implanted dopant atoms are activated with a conventional thermal process, for 30 minutes at a temperature of 900-1050°C. Subsequently, a second, high-dose, ion implantation is carried out, in the example, of an N type with atoms of arsenic (As) or phosphorous (P) with a dose of 10¹⁴ to 10¹⁵ atoms/cm² and an energy of 20-80 keV, for the formation of source/drain regions 28 within the body wells 26, in a position adjacent to the gate structures 24.

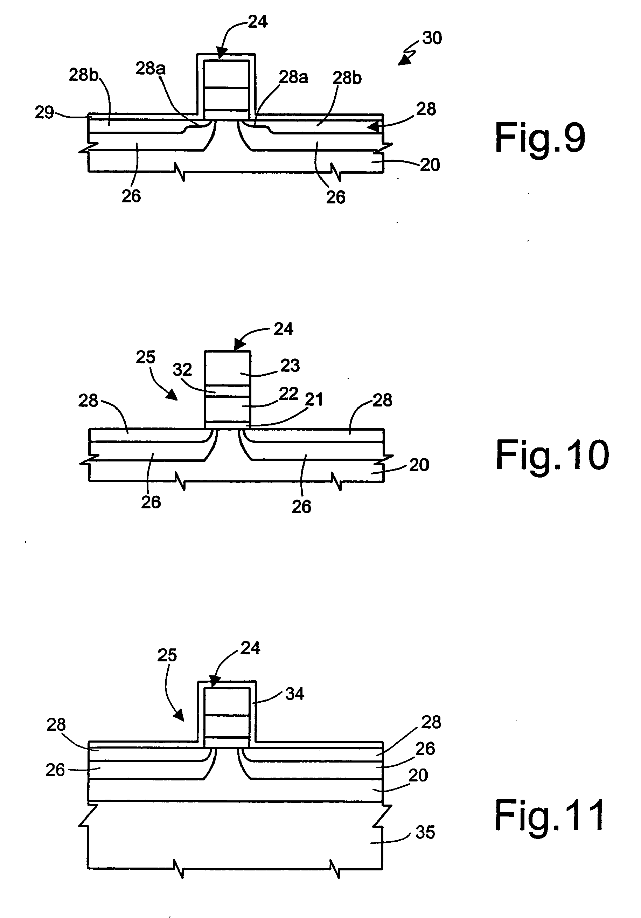

Next (see Figure 8), a dielectric, conformable, capping layer 29 is deposited on the gate structures 24 and the source/drain regions 28; for instance, the dielectric capping layer 29 is made of silicon oxide SiOₓ, or silicon nitride Si_{y}N_{z}, or a combination of both, and has a thickness equal to an odd multiple m_{odd} of the factor λ/2/η₂, where η₂ is the relative refraction index of the dielectric capping layer 29. Again, in the event that X = 308 nm and the dielectric capping layer 29 comprises a silicon oxide, the factor λ/2/η₂ is about 50 nm, and the thickness of the dielectric capping layer 29 is equal to m_{odd} · 50 nm. The dielectric capping layer 29 moreover coats the side walls of the gate structures 24, forming lateral containment spacers. In particular, said spacers are thin and have a thickness of up to ten times smaller than the spacers described with reference to the prior art, in particular of 10-100 nm. An ELA process is then carried out, for instance with an XeCl excimer laser with a wavelength λ of 308 nm and an energy density of between 600 and 800 mJ/cm². In particular, as previously described, the laser irradiation, schematically represented by the arrows in Figure 9, is performed with a split laser beam having a first component 12a and a second component 12b, inclined, respectively, by an incidence angle +α and -α with respect to the normal n to the top surface 20a of the layer 20. The incidence angle α is, in absolute value, comprised between 10° and 50°, preferably equal to 30°.

During irradiation, the portions of the dielectric capping layer 29 on the source/drain regions 28, having a thickness equal to an odd multiple m_{odd} of λ/2/η₂, exhibit, as it is known, minimum reflectivity to the laser irradiation and thus enable activation of the dopants in the underlying silicon region; whereas the portions of the dielectric capping layer 29 on the gate structures 24, having a thickness equal to (n_{odd} · λ/2/η₁ + m_{odd} · λ/2/η₂), i.e., in the example, equal to an even multiple of 50 nm, exhibit maximum reflectivity to the laser irradiation, thus acting as protection layers for the underlying gate electrodes. Furthermore, as previously described, the particular inclination of the laser radiation enables effective irradiation of the peripheral portions of the source/drain regions 28, especially in the area below the spacers and the gate structures 24.

At the end of the ELA irradiation process, the MOS device 30 of Figure 9 is thus obtained, which has uniformly doped source/drain regions 28 comprising a peripheral portion 28a, and a central portion 28b, adjacent to the peripheral portion 28a, which have substantially the same sheet resistance (and are formed through the same dopant introduction). The peripheral portions 28a are arranged in a position adjacent to, and partially below, the gate structures 24, and have the function of channel of the MOS transistors. Furthermore, the peripheral portions 28a have a smaller depth with respect to the central portion 28b, in particular smaller than 100 nm, and a sheet resistance smaller than 200 Ω/sq. During the annealing process for dopant activation, the dopant atoms diffuse for a depth equal to the depth of the molten region; the silicon region that melts during irradiation has a smaller thickness in the area below the spacers and the gate structures 24, whence the conformation of the peripheral portions 28a of the source/drain regions 28. In any case, the lateral diffusion of the peripheral portions 28a is precisely controlled as a function of the irradiation energy and as a function of the inclination of the laser beams.

The manufacturing process ends with the definition of contacts and metallizations, in a per-se known manner which is not described in detail.

A possible variation of the manufacturing process envisages a different construction of the gate structures 24, and in particular of the gate electrodes. In detail (see Figure 10), a low-resistivity metallic layer 32, in particular, of a metal or a metallic silicide, for instance W, Ti, Ta, CoSiₓ, PtSiₓ, TiSiₓ, WSiₓ, and having a thickness of 10-100 nm, is arranged between the polysilicon layer 22 and the dielectric layer 23. The low-resistivity metallic layer 32 has the function of protecting and shielding the underlying polysilicon layer during the laser irradiation, and further, advantageously, of reducing the MOS device gate resistance.

A further variation of the manufacturing process (see Figure 11), envisages the deposition of a metallic capping layer 34, instead of the dielectric capping layer 29, on top of the gate structures 24 and of the source/drain regions 28. The metallic capping layer 34 has a thickness of 5-50 nm, and is made of a metal, or a metal oxide or metal nitride, for instance W, Ta, TiN, TaN, and has a melting temperature higher than that of silicon, so as not to melt during the laser-annealing step. In particular, said layer transmits the irradiation energy to the underlying silicon with a controlled temperature profile. At the end of the irradiation process, and prior to definition of the contacts and of the metallizations, the metallic capping layer 34 is removed. According to said process variation, the dielectric layer 23 has a thickness of 200-600 nm.

In addition, according to a further variation of the manufacturing process, which is also illustrated in Figure 11, the layer 20, in which the MOS device active areas are formed, comprises an epitaxial layer grown on top of a substrate 35, the substrate and the epitaxial layer having the same type of conductivity and different doping concentrations.

The advantages of the described manufacturing process are clear from the foregoing description.

In any case, it is emphasized that the particular direction of the irradiation enables a more uniform temperature distribution within the source/drain regions 28, and hence a reduction of the irradiation energy density. Consequently, the spacers arranged laterally with respect to the gate structures 24, for mechanical containment of the molten silicon, can be thin, and the source/drain regions can be formed with a single process of ion implantation and activation. Furthermore, the diffusion of the peripheral portions 28a of the source regions, arranged partially underneath the gate structures 24, is accurately controlled during the irradiation process, in particular as a function of the energy density and as a function of the incidence angle of the laser beams.

Formation of the low-resistivity metallic layer 32 on the gate electrode is advantageous for further reducing the risk of deformations of the gate electrode; likewise, advantageous is the use of the metallic capping layer 34 to obtain an even more accurate control of the laser irradiation process.

Finally, it is clear that modifications and variations can be made to what is described and illustrated herein, without thereby departing from the scope of the present invention, as defined in the appended claims.

In particular, the irradiation process, instead of being carried out by means of a laser beam split into two components, can be performed with two laser beams coming from two distinct sources, one being inclined with the incidence angle +α, and the other with the incidence angle -α with respect to the normal n. Furthermore, the first and second incidence angle of the two laser beams could have different absolute values.

The dopant species used for the implants can be reversed to obtain P-channel transistors, instead of N-channel transistors.

Furthermore, the irradiation process can achieve the annealing of doped source regions, or doped drain regions. In particular, it can be advantageously used for the manufacturing of both vertical diffused MOS devices and lateral MOS devices.

Finally, a different type of excimer laser could be used for the annealing process, for example an XeF laser (with a wavelength X of 351 nm), KrF (λ = 248 nm), or ArF (λ = 193 nm), or other lasers having a wavelength within the ultraviolet spectrum.

## Claims

1. A process for manufacturing a MOS device (30), comprising:
- forming a gate structure (24) on a top surface (20a) of a semiconductor layer (20);
- forming a doped source/drain region (28) within a surface portion of said semiconductor layer (20) in a position adjacent to said gate structure (24); and
- irradiating said doped source/drain region (28) with an electromagnetic radiation (12a, 12b),
**characterized in that** irradiating comprises directing said electromagnetic radiation (12a, 12b) towards said top surface (20a), with a direction of propagation having an incidence angle (+α, -α) with respect to the normal (n) to said top surface (20a), said incidence angle (+α, -α) being non-zero.

2. The process according to claim 1, wherein irradiating comprises generating a first beam and a second beam of electromagnetic radiation (12a, 12b), and wherein directing comprises directing towards said top surface (20a) said first and said second beams of electromagnetic radiation (12a, 12b) with opposite incidence angles with respect to said normal (n), said first beam of electromagnetic radiation (12a) having a first incidence angle (+α), and said second beam of electromagnetic radiation having a second incidence angle (-α), opposite to said first incidence angle (+α).

3. The process according to claim 2, wherein generating comprises: emitting an original beam of electromagnetic radiation (12); and splitting said original beam of electromagnetic radiation (12) into said first beam of electromagnetic radiation (12a) and said second beam of electromagnetic radiation (12b) via a beam-splitter system (10).

4. The process according to claim 2 or claim 3, wherein said first and second incidence angle (+α, - α) have a substantially equal absolute value, said absolute value being smaller than 90°, in particular between 10° and 50°, preferably equal to 30°.

5. The process according to any one of the preceding claims, wherein said electromagnetic radiation (12a, 12b) is a laser radiation.

6. The process according to claim 5, wherein said laser radiation is an excimer-laser radiation, said excimer laser being chosen in the group comprising: XeCl, XeF, KrF, and ArF.

7. The process according to any one of the preceding claims, wherein said electromagnetic radiation (12a, 12b) has an energy density of between 600 and 800 mJ/cm².

8. The process according to any one of the preceding claims, wherein forming a gate structure (24) comprises:
- forming a first layer of dielectric material (21) on said semiconductor layer (20);
- forming a layer of conductive material (22, 32) on said first layer of dielectric material (21);
- forming a second layer of dielectric material (23) on said layer of conductive material (22, 32); and
- selectively removing portions of said first layer of dielectric material (21), of said layer of conductive material (22, 32), and of said second layer of dielectric material (23), thereby forming said gate structure (24).

9. The process according to claim 8, wherein said step of forming a layer of conductive material (22, 32) comprises forming a first region of conductive material (22) on top of said layer of dielectric material (21); and forming a second region of conductive material (32) on top of said first region of conductive material (22); said first region of conductive material (22) comprising polysilicon, and said second region of conductive material (32) comprising a metal or a metallic silicide, chosen preferably in the group comprising: W, Ti, Ta, CoSiₓ, PtSiₓ, TiSiₓ, WSiₓ.

10. The process according to any one of the preceding claims, comprising forming a capping layer (29) on top and at the sides of said gate structure (24), prior to irradiating; said capping layer (29) comprising one or more dielectric materials, preferably chosen in the group comprising: silicon oxide Sioₓ, or silicon nitride Si_{y}N_{z}.

11. The process according to any one of claims 1-9, comprising forming a capping layer (34) on top and at the sides of said gate structure (24), prior to irradiating; said capping layer (34) comprising a metal material, a metallic oxide, or a metallic nitride, preferably chosen in the group comprising: W, Ta, TiN, TaN.

12. The process according to any one of the preceding claims, wherein said gate structure comprises at least two gate portions (24) separated by a source/drain window (25) in a given direction (x), directing comprising: directing said electromagnetic radiation (12a, 12b) within said source/drain window (25); and controlling said incidence angle (+α, -α) in such a manner that said electromagnetic radiation (12a, 12b) preferentially reaches peripheral portions (28a) of said doped source/drain region (28), arranged in a position adjacent to, and partially underneath, said gate structure (24).

13. The process according to any one of the preceding claims, wherein said semiconductor layer (20) has a first type of conductivity; moreover comprising forming a body region (26) having a second type of conductivity within said semiconductor layer (20), laterally with respect to, and partially below, said gate structure (24); and wherein forming a doped source/drain region comprises forming said doped source/drain region (28) within said body region (26), with said first type of conductivity.

14. A MOS device (30) comprising:
- a semiconductor body (20) having a top surface (20a);
- a gate structure (24) arranged on the top surface (20a) of said semiconductor body (20); and
- a doped source/drain region (28), formed within a surface portion of said semiconductor body (20) in a position adjacent to said gate structure (24), said doped source/drain region (28) comprising a first portion (28a) arranged partially underneath said gate structure (24), and a second portion (28b), adjacent to said first portion (28a), and having a thickness greater than said first portion (28a);
**characterized in that** said doped source/drain region (28) is a region doped in a substantially uniform way.

15. The MOS device according to claim 14, wherein said first portion (28a) and said second portion (28b) of said doped source/drain region (28) have a sheet resistance that is substantially equivalent.

16. The MOS device according to claim 14 or claim 15, wherein said first portion (28a) has a thickness smaller than or equal to 100 nm, and has a sheet resistance smaller than or equal to 200 Ω/sq.

17. The MOS device according to any one of claims 14-16, wherein said gate structure (24) comprises a first region of dielectric material (21) arranged on said semiconductor body (20), a region of conductive material (22, 32) arranged on said first region of dielectric material (21), and a second region of dielectric material (23) arranged on said region of conductive material (22, 32); said region of conductive material (22, 32) comprising a portion of polysilicon (22) surmounted by a portion of metal material (32), comprising a metal or a metallic silicide, preferably chosen in the group comprising: W, Ti, Ta, CoSiₓ, PtSiₓ, TiSiₓ, WSiₓ.

18. The MOS device according to any one of claims 14-17, further comprising a capping region (34) arranged on top and at the sides of said gate structure (24) and on said doped source/drain region (28); said capping region (34) comprising a metal material, a metallic oxide, or a metallic nitride, preferably chosen in the group comprising: W, Ta, TiN, TaN,.
